(19) Europäisches Patentamt
European Patent Office
Office européen des brevets

(11) **EP 3 298 693 B1**

(12) **EUROPÄISCHE PATENTSCHRIFT**

(45) Veröffentlichungstag und Bekanntmachung des Hinweises auf die Patenterteilung:
**08.07.2020 Patentblatt 2020/28**

(51) Int Cl.:
*H03K 7/06* (2006.01)   *H03K 7/08* (2006.01)
*H03K 5/04* (2006.01)

(21) Anmeldenummer: **16723738.7**

(22) Anmeldetag: **18.05.2016**

(86) Internationale Anmeldenummer:
**PCT/EP2016/061109**

(87) Internationale Veröffentlichungsnummer:
**WO 2016/188815 (01.12.2016 Gazette 2016/48)**

(54) **VERFAHREN UND ELEKTRONISCHE VORRICHTUNG ZUR PULSMODULIERTEN ANSTEUERUNG EINES VERBRAUCHERS**

METHOD AND ELECTRONIC DEVICE FOR THE PULSE-MODULATED ACTUATION OF A LOAD

PROCÉDÉ ET DISPOSITIF ÉLECTRONIQUE DE COMMANDE À MODULATION D'IMPULSIONS D'UN CONSOMMATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.05.2015 DE 102015209469**

(43) Veröffentlichungstag der Anmeldung:
**28.03.2018 Patentblatt 2018/13**

(73) Patentinhaber: **Continental Teves AG & Co. OHG 60488 Frankfurt am Main (DE)**

(72) Erfinder:
• **CHEN, Ling**
  **64295 Darmstadt (DE)**
• **HEINZ, Micha**
  **64289 Darmstadt (DE)**
• **MICHEL, Frank**
  **61191 Rosbach v. d. Höhe (DE)**

(56) Entgegenhaltungen:
**US-A1- 2008 157 894    US-A1- 2010 090 775**
**US-A1- 2013 015 798**

**Beschreibung**

Die vorliegende Erfindung betrifft ein Verfahren gemäß Oberbegriff von Anspruch 1 und eine elektronische Vorrichtung gemäß Oberbegriff von Anspruch 9.

In elektronischen Steuergeräten für ABS und ESP wird häufig eine pulsweitenmodulierte (PWM) Ansteuerung verwendet, um eine Digital-Analog-Wandlung, beispielsweise für die Ventilansteuerung, den Betrieb der Pumpe oder helligkeitssteuerbare Warnlampen, zu realisieren. Ein solches Verfahren ist beispielsweise in der DE 10 2012 213 874 A1 beschrieben, wobei zur Begrenzung von Spitzenströmen sowie der maximalen Steigung der Stromflanken bei der Ansteuerung eines Pumpenmotors eine Änderung eines Ist-Tastgrades der PWM von einem ersten Tastgrad auf einen zweiten Tastgrad erfolgt. Üblicherweise werden die PWM-Ansteuerungen von integrierten Schaltkreisen (Mikrocontroller und Gemischtsignalschaltkreis) erzeugt. Nachteilig an der Ansteuerung mit einem pulsweitenmodulierten Signal kann jedoch sein, dass es durch das häufige Ein- bzw. Ausschalten der Ausgangstreiberstufen zu einer erhöhten elektromagnetischen Abstrahlung kommt und/oder das Energieversorgungsnetz im Fahrzeug gestört wird. Eine gewählte, feste PWM-Frequenz kann sich auch als unerwünschtes Geräusch im Fahrzeug bemerkbar machen. Diese Nachteile werden mit teilweise aufwändigen Mitteln außerhalb der integrierten Schaltkreise kompensiert, so z.B. Stabilisierungsschaltungen für die Spannungsversorgung auf der Ebene des elektronischen Steuergeräts oder geräuschunterdrückende Maßnahmen im Fahrzeug.

Die US 2008/157894 A1 zeigt ein Verfahren und eine Vorrichtung zur Modellierung einer Frequenz eines periodischen Signals eines Tastgrades, um elektromagnetische Störungen zu reduzieren. Dabei wird ein Trägersignal moduliert, welches eine höhere Frequenz als die PWM aufweist. Anschließend wird das PWM-Signal mit diesem Trägersignal neu getaktet.

Die US 2013/015798 A1 zeigt zudem ein Verfahren zum Verteilen von elektromagnetischen Störungen über verschiedene Frequenzen während ein konstanter Tastgrad erhalten bleibt.

Aufgabe der Erfindung ist es, ein Mittel bereitzustellen, womit eine Verbesserung der elektromagnetischen Verträglichkeit, insbesondere der Störaussendung, sowie eine Verringerung der Emission von Störschall ermöglicht werden und das möglichst kostengünstig realisierbar sein soll.

Diese Aufgabe wird durch ein Verfahren gemäß Anspruch 1 und eine elektronische Vorrichtung gemäß Anspruch 9 gelöst.

Die Erfindung beschreibt ein Verfahren zur pulsmodulierten Ansteuerung eines Verbrauchers in einem Fahrzeug, wobei eine Periodendauer der Pulsmodulation in eine ganzzahlige Anzahl an Abschnitten unterteilbar ist, deren Dauer jeweils einem Vielfachen einer Periodendauer eines Taktsignals entspricht, und das sich weiterhin dadurch auszeichnet, dass dieses die Schritte aufweist:

- Berechnen einer Frequenz oder Periodendauer einer Periode der Pulsmodulation auf Basis einer zugrundeliegenden Frequenzmodulation und
- Festlegen der Dauer eines jeweiligen Abschnittes der Periodendauer der Pulsmodulation unter Heranziehung der berechneten Frequenz oder Periodendauer einer Periode der Pulsmodulation.

In vorteilhafter Weise kann somit eine Implementierung einer Frequenzmodulation, insbesondere zur Ausführung durch eine Digitalschaltung innerhalb eines Digitalschaltkreises oder eines Gemischtsignalschaltkreises (Hardware-Implementierung), realisiert werden, wodurch eine kostengünstige Herstellung und ein ressourcenschonender Betrieb möglich ist. Es können Frequenzen erzeugt werden, deren Abschnitte nicht durch ganzzahlige Vielfache des Taktsignals generiert werden können, was eine vergleichsweise fein durchstimmbare Frequenzmodulation möglich macht. Durch die Frequenzmodulation kann die Störenergie vorteilhafterweise auf ein breites Frequenzband verteilt werden, womit eine Verbesserung der elektromagnetischen Verträglichkeit, insbesondere der Störaussendung, sowie eine Verringerung der Emission von Störschall der zugrundeliegenden elektronischen Vorrichtung machbar werden.

Üblicherweise ist das Taktsignal ein periodisches Taktsignal, welches von einem Oszillator erzeugt wird, kann jedoch auch ein von diesem, zum Beispiel mittels Frequenzteiler, abgeleitetes Taktsignal sein. Das pulsmodulierte Signal dient dabei insbesondere zur Ansteuerung einer Endstufe, welche das Schalten des oder der Laststromkreise der Verbraucher vornimmt, wodurch sich entsprechend der Ansteuerung ein mittlerer Strom oder eine mittlere Spannung einstellt. Je nach Realisierung der Schaltung ist das Ansteuersignal für eine vorgegebene Anzahl an Abschnitten beispielsweise '1' (Impuls) und für den weiteren Verlauf der PWM-Periode ist die Ansteuerung '0'. Durch die Frequenzmodulation gestaltet sich die Dauer einer Periode der Pulsmodulation variabel. Dennoch kann die vorgegebene Anzahl an Abschnitten, welche den Impuls bilden, bevorzugt ebenfalls vorgegeben werden, sodass z.B. eine zeitliche Konstanz der Pulsbreite über den Frequenzbereich der Frequenzmodulation oder eine zusätzliche Pulsweitenmodulation für jede Ansteuerfrequenz realisierbar ist. Insofern kann es sich gemäß der Erfindung um eine der Pulsweitenmodulation überlagerte Pulsfrequenzmodulation, eine reine Pulsfrequenzmodulation oder eine der Pulsfrequenzmodulation überlagerte Pulsweitenmodulation handeln.

Zur Bestimmung der Dauer der Abschnitte einer Periode der Pulsmodulation werden entsprechend der Erfindung die folgenden Schritte vorgenommen, wobei $R_{STEP}$ einen Restwert, fosc eine Frequenz des Taktsignals, N die Anzahl Abschnitte und $f_{PWM}$ die Frequenz der Pulsmodulation repräsentiert:

1. Initialisierung des Rests mit einem Wert gleich Null zu Beginn einer Periode der Pulsmodulation,

$$R_{STEP} \overset{\leftarrow}{=} R_{STEP} + \frac{f_{OSC}}{N} - f_{PWM}$$ am Anfang eines Abschnitts,

2. Ausführung einer Zuweisung:

3. Ausführung einer Zuweisung: $R_{STEP} = R_{STEP} - f_{PWM}$ im Anschluss einer Periode des Taktsignals und

4. Beendigung des Abschnitts und Ausführung des 2. Schrittes, wenn der Rest kleiner als die Frequenz der Periode der Pulsmodulation, und andernfalls Wiederholung des 3. Schrittes.

Bei den Berechnungen bzw. Zuweisungen können gegebenenfalls zusätzliche Parameter und/oder Konstanten Berücksichtigung finden und/oder die Berechnungen als solches - bei im Wesentlichen gleichem Ergebnis - in alternative Weise erfolgen.

Die Anzahl der Abschnitte innerhalb einer Periode der Pulsmodulation wird vorzugsweise als zweier-Potenz gewählt, wobei der Exponent ganzzahlig ist. Eine Division durch N (siehe 2. Schritt) entspricht dadurch einer Schiebeoperation um die im Exponent angegebene Anzahl an Stellen, wodurch eine ressourcenschonende Berechnung, auch für eine Implementierung in Hardware, ermöglicht wird. Innerhalb einer Ansteuerung ist der Ausdruck $f_{OSC}/N$ (2. Schritt) zweckmäßigerweise konstant.

Gemäß einer bevorzugten Weiterbildung des Verfahrens erfolgt die Berechnung der Frequenz oder Periodendauer einer Periode der Pulsmodulation mittels einer rekursiven Berechnung, wobei eine Frequenz oder Periodendauer einer vorhergehenden Periode der Pulsmodulation herangezogen wird. Multiplikation und Division können damit parallel durch Additionen und Subtraktionen realisiert werden.

Die Frequenz oder Periodendauer einer nachfolgenden Periode der Pulsmodulation wird vorzugsweise während einer laufenden Periode der Pulsmodulation berechnet. Alternativ ist eine Berechnung beispielsweise der Frequenz oder Periodendauer einer laufenden Periode der Pulsmodulation während - insbesondere vergleichsweise kurz nach deren Beginn - der laufenden Periode der Pulsmodulation möglich.

Die Frequenz oder Periodendauer einer nachfolgenden Periode der Pulsmodulation wird während einer laufenden Periode der Pulsmodulation bevorzugt genau einmal berechnet. Vorteilhafterweise wird damit eine ressourcenschonendere Berechnung der Frequenz oder Periodendauer der nachfolgenden Periode ermöglicht.

Ein Rest, welcher sich bei der Berechnung der Frequenz oder Periodendauer der Periode der Pulsmodulation ergibt, wird bevorzugt innerhalb einer nachfolgenden Periode der Pulsmodulation berücksichtigt. Dadurch wird der Fehler, der bei der Berechnung der Frequenz oder Periodendauer der nachfolgenden Periode der Pulsmodulation gemacht wird, berücksichtigt.

Bevorzugt folgt die zugrundeliegende Frequenzmodulation einem vorgegebenen Frequenzänderungsverlauf. Dies ermöglicht eine Optimierung beispielsweise hinsichtlich der Vermeidung bestimmter Frequenzen zur Verringerung der Störaussendung. Zweckmäßigerweise wird dabei die Frequenz des pulsmodulierten Signals zwischen einer minimalen Frequenz und einer maximalen Frequenz variiert.

Für die Berechnung der Frequenz oder Periodendauer der Periode der Pulsmodulation wird die Näherung herangezogen, dass die Frequenzen aufeinanderfolgender Perioden der Pulsmodulation oder die Periodendauern der Pulsmodulation annähernd gleich sind. Vorteilhafterweise kann ein in Folge der Näherung auftretender Fehler für eine Vielzahl an Anwendungen vernachlässigt werden.

Die Dauer der Abschnitte einer Periode der Pulsmodulation wird bevorzugt unter Heranziehung der Frequenz oder Periodendauer einer laufenden Periode der Pulsmodulation iterativ für jeden Abschnitt separat bestimmt. Dies ermöglicht eine besonders aufwandsgünstige Berechnung der Abschnittsdauern.

Gemäß einer Weiterbildung der Erfindung wird die Dauer eines jeweiligen Abschnittes der Periodendauer der Pulsmodulation weiterhin auf Grundlage eines Verhältniswerts der Dauer eines Abschnittes zur Periodendauer des Taktsignals bestimmt. Weiterhin beschreibt die Erfindung eine elektronische Vorrichtung zur pulsmodulierten Ansteuerung eines Verbrauchers in einem Fahrzeug, welche zumindest einen Schaltkreis zur Erzeugung eines pulsmodulierten Signals aufweist, der unter Heranziehung eines Taktsignals betreibbar ist, wobei eine Periodendauer des pulsmodulierten Signals in eine ganzzahlige Anzahl an Abschnitten unterteilbar ist, deren Dauer jeweils einem Vielfachen einer Periodendauer des Taktsignals entspricht, wobei sich die Vorrichtung zudem dadurch auszeichnet, dass der Schaltkreis zur Erzeugung eines pulsmodulierten Signals unterschiedlicher Periodendauern oder Frequenzen ausgestaltet ist, wobei das pulsmodulierte Signal innerhalb einer Periodendauer einen nicht ganzzahligen Mittelwert von Verhältniswerten der Dauer der Abschnitte einer Periode der Pulsmodulation zur Periodendauer des Taktsignals aufweisen kann. Die Berechnung der nächsten anzusteuernden Pulsmodulationsfrequenz wird somit mit einem geringen Schaltungsaufwand realisiert.

Der Schaltkreis ist entsprechend einer vorteilhaften Weiterbildung ausgestaltet, innerhalb einer Periodendauer des pulsmodulierten Signals Abschnitte unterschiedlicher Zeitdauern zu erzeugen.

Die elektronische Vorrichtung ist derart ausgestaltet, dass diese das erfindungsgemäße Verfahren ausführen kann bzw. ausgeführt wird.

Für die erfindungsgemäße Vorrichtung gelten im Wesentlichen die gleichen Vorteile, wie bereits für das erfindungsgemäße Verfahren beschrieben.

Weitere bevorzugte Ausführungsformen ergeben sich aus der nachfolgenden Beschreibung von Ausführungsbeispielen an Hand von Figuren.

In schematischer Darstellung zeigen:

Fig. 1 eine beispielgemäße Frequenzmodulation zur Erzeugung eines pulsmodulierten Signals (PM-Signals) mit einem ganzzahligen Teiler V = 2,

Fig. 2 eine beispielgemäße Frequenzmodulation zur Erzeugung eines PM-Signals mit einem mittleren Teiler V = 2,5 über eine Periode $T_{PWM}$ der Pulsmodulation (PM-Periode),

Fig. 3 ein beispielhafter Frequenzverlauf während einer Frequenzmodulation,

Fig. 4 ein beispielhafter Frequenzverlauf unter Verwendung einer rekursiven Berechnung der Pulsmodulationsfrequenz (PM-Frequenz),

Fig. 5 ein Beispiel einer binären, sequentiellen Berechnung des Terms $a \cdot \dfrac{b}{c}$ und

Fig. 6 eine beispielgemäße Frequenzmodulation zur Erzeugung eines PM-Signals mit einem mittleren Teiler $V_{PWM}$ = 2,6 über eine Periode $T_{PWM}$ der Pulsmodulation.

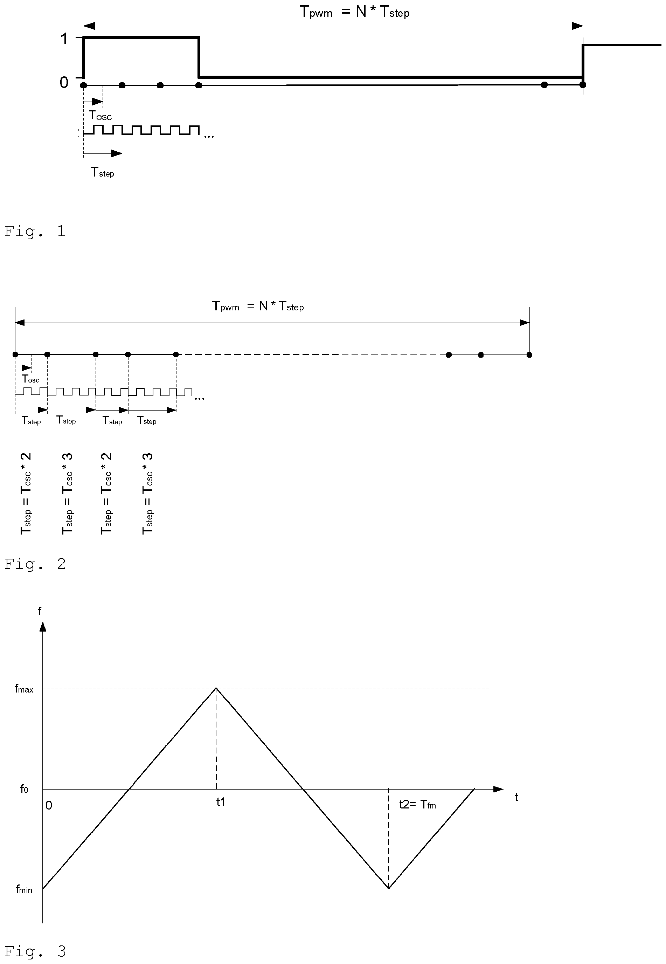

Fig. 1 zeigt ein Beispiel einer Periode einer üblichen PWM-Ansteuerung. Synchrone digitale Schaltungen werden mittels eines Basistakts mit der Periodendauer $T_{OSC}$ bzw. mittels eines von diesem abgeleiteten Taktsignal betrieben. Eine PWM-Periode der Dauer $T_{PWM}$ ist dabei in N Abschnitte der Dauer $T_{STEP}$ unterteilt, wobei jeder Abschnitt der Länge $T_{STEP}$ einer ganzzahligen Anzahl von Takten der Periodendauer $T_{OSC}$ des Basistakts entspricht. Das Verhältnis $T_{STEP}/T_{OSC}$ wird durch Teiler $V_{PWM}$ bestimmt. Gemäß dem Beispiel der Fig. 1 ist Teiler V = 2.

In Abhängigkeit eines einzustellenden mittleren Stromes zur Ansteuerung eines Verbrauchers ist das Ansteuersignal innerhalb der PWM-Periode für eine bestimmte Anzahl von Abschnitten '1 ' und für den weiteren Verlauf der PWM-Periode ist die Ansteuerung '0'. Dieses PWM-Signal kann dazu verwendet werden, um z.B. einen Pumpentreiber ein- bzw. auszuschalten.

Die Abschnittsweite $T_{STEP}$ innerhalb einer PWM-Periode ist dabei konstant. Somit ergeben sich in Abhängigkeit vom Basistakt mit der Schrittweite $T_{OSC}$ bestimmte diskrete Periodendauern $T_{PWM}$:

$$T_{PWM} = T_{STEP} \cdot N = T_{OSC} \cdot V_{PWM} \cdot N$$

wobei die Werte von $V_{PWM}$ und N ganzzahlig sind.

Dies stellt insbesondere in Gemischtsignalschaltkreisen eine deutliche Einschränkung dar, da in diesen Fällen die Oszillatorfrequenz mit der Periodendauer $T_{OSC}$ nicht beliebig festgelegt werden kann. Wählt man z.B. eine Oszillatorfrequenz von 50 MHz und N = 1024, dann können nur die diskreten Frequenzen:

$f_{PWM1}$ = 48,8 kHz
$f_{PWM2}$ = 24,4 kHz
$f_{PWM3}$ = 16,3 kHz
$f_{PWM4}$ = 12,2 kHz
...

realisiert werden.

Fig. 2 zeigt ein Ausführungsbeispiel, bei welcher die Zeitdauern $T_{STEP}$ der Schritte innerhalb einer PM-Periode unterschiedliche Länge haben können, wobei diese weiterhin im ganzzahligen Verhältnis zum Basistakt der Periodendauer $T_{OSC}$ gebildet werden, bzw. eine unterschiedliche Anzahl Basistakten der Periodendauer $T_{OSC}$ aufweisen. Da nicht notwendigerweise eine reine Pulsweitenmodulation vorliegt, findet der allgemeinere Ausdruck Pulsmodulation (PM) Anwendung. Im Unterschied zur Ausführung gemäß Fig. 1 weisen die Zeitdauern $T_{STEP}$ der Schritte unterschiedliche Teiler $V_{PM}$ auf, sodass der Teiler $V_{PM}$ über die Periodendauer $T_{PM}$ der PM einen Mittelwert von 2,5 aufweist. Dies ermöglicht eine vergleichsweise fein durchstimmbare Frequenzmodulation der Periodendauern $T_{PM}$ der PM, wodurch eine Verteilung von Störenergie auf ein breites Frequenzband ermöglicht wird. Innerhalb einer PM-Periode beträgt der maximale Fehler durch dieses Vorgehen damit einen Basistakt $T_{OSC}$.

In Fig. 3 ist beispielhaft ein Frequenzverlauf während einer Frequenzmodulation dargestellt. Ausgehend von Mittenfrequenz $f_{PM} = 1/T_{PM}$ wird die Frequenz während des laufenden Betriebs eines zugrundeliegenden Systems bzw. während der Ansteuerung eines Verbrauchers mittels einer frequenzmodulierten Spannung oder eines frequenzmodulierten Stromes dreieckförmig zwischen den beiden Extremwerten $f_{MIN}$ und $f_{MAX}$ variiert. Die Modulationsfrequenz $f_{FM}$ $= 1/T_{FM}$ bestimmt dabei die Geschwindigkeit der Frequenzänderung.

Im Folgenden wird erläutert, wie ausgehend vom Frequenzverlauf gemäß Fig. 3 ein nichtganzzahliger Wert $V_{PM}$ berechnet werden kann, um eine PM-Ansteuerung entsprechend dem Beispiel der Fig. 2 zu erhalten.

Für die Berechnung sind folgende Werte gegeben:

$f_{PM} = 1/T_{PM}$      Gewünschte Mittenfrequenz der PM-Ansteuerung

$f_{MIN} = 1/T_{MIN}$      Minimale PM Ansteuerungsfrequenz

$f_{MAX} = 1/T_{MAX}$      Maximale PM Ansteuerungsfrequenz

$f_{FM} = 1/T_{FM}$      Modulationsfrequenz

$f_{OSC} = 1/T_{OSC}$      Basistakt der digitalen Schaltung

Der Frequenzverlauf gemäß Fig. 3 lässt sich allgemein als Funktion darstellen:

$$f(t) = \frac{f_{MAX} - f_{MIN}}{t_1} \cdot t + f_{MIN} = \frac{2 \cdot (f_{MAX} - f_{MIN})}{T_{FM}} \cdot t + f_{MIN} \quad \text{für} \quad 0 \le t \le t_1$$

$$f(t) = \frac{f_{MIN} - f_{MAX}}{t_2 - t_1} \cdot (t - t_1) + f_{MAX} = -\frac{2 \cdot (f_{MAX} - f_{MIN})}{T_{FM}} \cdot (t - t_1) + f_{MAX} \quad \text{für} \quad t_1 \le t \le t_2$$

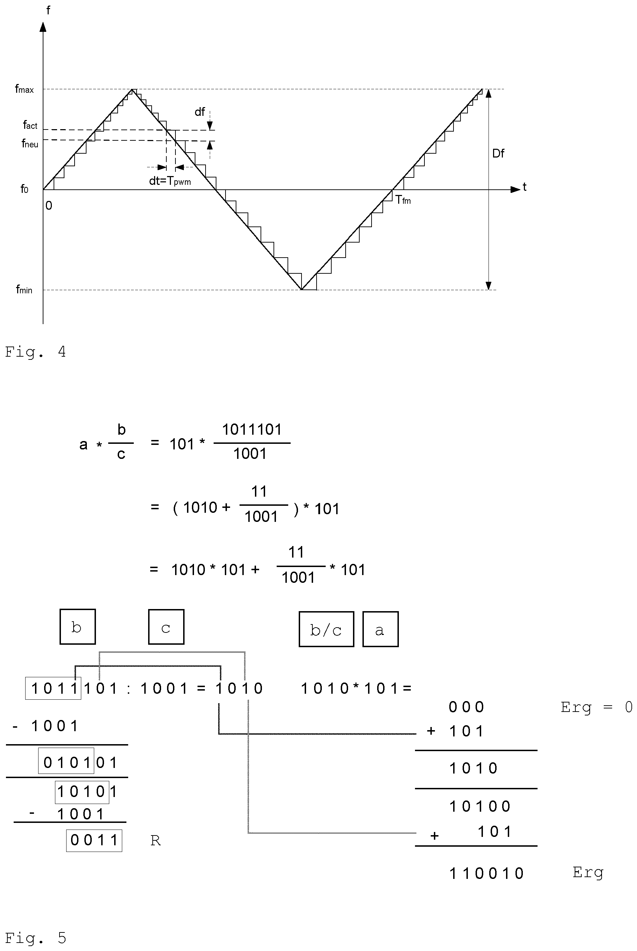

Innerhalb einer digitalen Schaltung zur PM-Ansteuerung ist die Berechnung der Frequenz für beliebige Zeiten t nicht zwangsläufig notwendig, da im Besonderen der Abstand zweier aufeinanderfolgender steigender Signalflanken als Periodendauer $T_{PM}$ relevant ist. Es reicht daher im Allgemeinen aus, die PM-Frequenz mit der Periodendauer $T_{PM}$ einmal pro PM-Periode zu berechnen. Für die Berechnung der PM-Frequenz $f_{PM+1}$ der nächsten PM-Periode wird erfindungsgemäß ein rekursives Verfahren herangezogen, welches anhand von Fig. 4 erläutert wird, wobei gilt:

$$df = f_{PM+1} - f_{PM} = \pm \frac{f_{MIN} - f_{MAX}}{T_{FM}/2} \cdot dt = \pm \frac{2 \cdot (f_{MIN} - f_{MAX})}{T_{FM}} \cdot T_{PM}$$

$$f_{PM+1} = df + f_{PM} = \pm \frac{2 \cdot (f_{MIN} - f_{MAX}) \cdot f_{FM}}{f_{PM}} + f_{PM}$$

$$f_{PM+1} = \frac{k}{f_{PM}} + f_{PM} \quad mit \quad k = \pm 2 \cdot (f_{MAX} - f_{MIN}) \cdot f_{FM}$$

Das Vorzeichen $\pm$ unterscheidet dabei jeweils, ob eine steigende oder eine abfallende Flanke der PM-Frequenz vorliegt. Die sich mit der PM-Frequenz ändernden Schrittweiten df und dT ergeben sich aufgrund der sich mit der PM-Frequenz ändernden PM-Periodendauer.

Zur Bestimmung der Frequenz $f_{PM+1}$ erfolgt eine Berechnung der Form:

$$a \cdot \frac{b}{c} \quad mit \quad a = (f_{MAX} - f_{MIN}), b = f_{FM} \text{ und } c = f_{PM}$$

Es gibt unzählige Wege den Term $a \cdot \dfrac{b}{c}$ zu berechnen.

Das Ausführungsbeispiel entsprechend Fig. 5 zeigt dabei eine mögliche ressourceneffiziente Vorgehensweise zur binären, sequentiellen Berechnung desselben. Entsprechend dieser wird weder ein Multiplizierer noch ein Dividierer benötigt, was innerhalb von Digitalschaltungen vorteilhaft ist, da Addierer, Subtrahierer und Schiebeoperation vergleichsweise einfach und Multiplizierer sowie Dividierer erheblich aufwändiger zu realisieren sind.

In dem Berechnungsbeispiel gemäß Fig. 5 wurden folgende Bitbreiten für die Variablen a, b und c gewählt: $n_a = 3$, $n_b = 7$ und $n_c = 4$.

Es werden die nachfolgenden Verfahrensschritte ausgeführt:

1. Der Wert Erg wird mit 0 initialisiert, ein Schrittzähler wird ebenfalls auf 0 gesetzt und ein Maximalwert ($>= n_b - n_c$) für den Schrittzähler festgelegt, welcher die Rechengenauigkeit vorgibt.

2. Sind die ersten $n_c$ Bits der Variable b größer oder gleich dem Wert von c, wird c von den ersten $n_c$ Bits von b abgezogen. Gleichzeitig wird a zu Wert Erg hinzuaddiert. Sind die ersten $n_c$ Bits von b kleiner als c, wird dieser Schritt übersprungen und Schritt 3 ausgeführt.

3. Der Schrittzähler wird um 1 erhöht. Hat der Schrittzähler den Maximalwert nicht erreicht, wird b und Erg um ein Bit nach links geschoben und zu Schritt 2 gesprungen. Hat der Zähler den Maximalwert erreicht, ist der Rechenvorgang beendet.

Erg repräsentiert nun das Resultat der Rechenoperation aus Multiplikation und Division. Diese Berechnung wird in jeder PM-Periode durchgeführt, um die PM-Frequenz $f_{PM+1}$ der nächsten PM-Periode zu bestimmen. Bei dieser Operation tritt häufig ein Divisionsrest R auf, der bevorzugt im nächsten Iterationsschritt bzw. bei der Berechnung der PM-Frequenz der PM-Periode berücksichtigt wird, welche auf die nächste PM-Periode folgt:

$$f_{PM+1} = \frac{k}{f_{PM}} + \frac{R}{f_{PM-1}} + f_{PM} \qquad \text{mit } k = \pm 2 \cdot (f_{MAX} - f_{MIN}) \cdot f_{FM}$$

Dabei repräsentiert $f_{PM-1}$ die PM-Frequenz der vorhergehenden PM-Periode, $f_{PM}$ die PM-Frequenz der aktuellen PM-Periode und $f_{PM+1}$ die PM-Frequenz der nächsten PM-Periode. Dies würde jedoch eine zusätzliche Divisionsoperation bzw. mehrere zusätzliche Subtraktions- und Schiebeoperationen erfordern. Zur weiteren Vereinfachung bei der Berechnung der nächsten PM-Frequenz wird davon ausgegangen, dass zwei aufeinanderfolgende PM-Perioden sehr ähnlich sind, sodass gilt: $f_{PM-1} \approx f_{PM}$

Und man erhält:

$$f_{PM+1} = \frac{R}{f_{PM-1}} + \frac{k}{f_{PM}} + f_{PM} \approx \frac{R+k}{f_{PM}} + f_{PM} \qquad \texttt{Gleichung 1}$$

Aus der mittels Gleichung 1 berechneten Frequenz $f_{PM+1}$ kann der Teiler $V_{PM+1}$ der nachfolgenden PM-Periode bestimmt werden:

$$T_{STEP} = V_{PM+1} \cdot T_{osc}$$

$$V_{PM+1} = \frac{T_{STEP}}{T_{OSC}} = \frac{T_{PM}/N}{T_{OSC}} = \frac{f_{OSC}}{N \cdot f_{PM+1}}$$

Der Wert $V_{PM+1}$ ist im Allgemeinen nicht ganzzahlig. Wie bereits für Fig. 2 erläutert, werden dadurch die Schrittweiten innerhalb einer PM-Periode unterschiedlich lang. Zweckmäßigerweise wird aus Gründen der Ressourceneinsparung auch hier eine Divisionsoperation vermieden.

In digitalen Schaltungen wird die Zahl N der Schritte mit der Periodendauer $T_{STEP}$ innerhalb einer PM-Periode bevorzugt als 2er-Potenz gewählt, d.h. $N = 2^M$, wobei M ganzzahlig ist. Die Division durch N entspricht dadurch einer Schiebeoperation um M Stellen. Innerhalb einer PM-Ansteuerung ist der Ausdruck $f_{OSC}/N$ zweckmäßigerweise konstant, sodass sich eine besonders ressourceneffiziente Berechnung realisieren lässt.

Die eigentliche Zeitdauer $T_{STEP}$ der Abschnitte einer PM-Periode bzw. Anzahl der Basistaktperioden $T_{OSC}$ des jeweiligen Abschnitts wird mit folgendem Algorithmus iterativ bestimmt:

1. Zu Beginn einer Pulsmodulationsperiode wird ein Rest $R_{STEP}$ mit 0 initialisiert.
2. Am Anfang eines Abschnitts der Länge $T_{STEP}$ wird die Zuweisung:

$$R_{STEP} \overset{\leftarrow}{=} R_{STEP} + \frac{f_{OSC}}{N} - f_{PM}$$

ausgeführt, wobei

$$R_{STEP} + \frac{f_{OSC}}{N} - f_{PM} = R_{STEP} + f_{PM} \cdot (V_{PM} - 1)$$

ist und $f_{PM}$ und $V_{PM}$ die unter Verwendung von Gl. 1 in der vorhergehenden PM-Periode ermittelten Werte $f_{PM+1}$ sowie $V_{PM+1}$ darstellen.

3. Nach einer Basistaktperiode $T_{OSC}$ wird die Zuweisung $R_{STEP} \overset{\leftarrow}{=} R_{STEP} - f_{PM}$ durchgeführt.
4. Ist Rest $R_{STEP}$ kleiner als $f_{PM}$, dann ist der Schritt $T_{STEP}$ zu Ende und es wird zu 2. gesprungen, um die Länge des nächsten Schritts zu bestimmen, andernfalls wird 3. wiederholt.

Die Frequenz $f_{PM+1}$ der nächsten Periode der Pulsmodulation lässt sich somit rekursiv anhand der Parameter $f_{OSC}/N$, $f_{MIN}$, $f_{MAX}$, $f_{FM}$ und $f_{PM}$ bestimmen, wobei insbesondere $f_{OSC}/N$, $f_{MIN}$, $f_{MAX}$, $f_{FM}$ auch über eine Vielzahl an Perioden der Pulsmodulation konstant bleiben können.

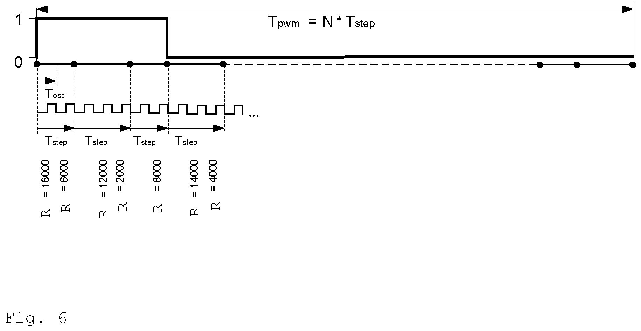

Fig. 6 zeigt ein Beispiel einer Berechnung der Schrittweite $T_{STEP}$. Für dieses Beispiel wurden folgende Eingangsgrößen verwendet:

$f_{OSC} = 6,656$ MHz
$N = 2^8 = 256$
$f_{PM} = 10$ kHz

Mit diesen Eingangsgrößen ergibt sich Teiler $V_{PM}$ zu 2,6.

Ein Rest $R_{STEP}$ bleibt von Schritt zu Schritt erhalten und ermöglicht, dass der gewünschte Wert von $V_{PM} = 2,6$ im Mittel erreicht wird.

Das PM-Ansteuerungssignal orientiert sich gemäß Fig. 6, wie auch für die Ausführungsform gemäß Fig. 1, an der Anzahl der Schritte der Schrittweite $T_{STEP}$ - unabhängig davon, dass diese Schrittweite nun leicht variiert. Innerhalb der PM-Periode $T_{PM}$ ist das Ansteuerungssignal für eine bestimmte Anzahl von Schritten der Schrittweite $T_{STEP}$ '1' und den weiteren Verlauf der PM-Periode ist die Ansteuerung '0'.

Abschätzung des maximalen Gesamtfehlers einer halben PM-Periode

Durch die Vereinfachung $f_{PM-1} \approx f_{PM}$ kommt es zu einem Fehler F, der bei jedem iterativen Rechenschritt auftreten kann:

$$F = \left| \frac{R + k}{f_{PM}} - \left( \frac{R}{f_{PM-1}} + \frac{k}{f_{PM}} \right) \right| = \left| \frac{R}{f_{PM}} - \frac{R}{f_{PM-1}} \right| = \left| R \cdot \frac{f_{PM-1} - f_{PM}}{f_{PM-1} \cdot f_{PM}} \right|$$

Innerhalb einer halben PM-Periode addieren sich die Fehler F einer PM-Periode zu einem Gesamtfehler $F_G$ einer halben PM-Periode:

$$F_G = \left| \sum_{T/2} F \right| = \left| \sum_{T/2} R \cdot \frac{f_{PM-1} - f_{PM}}{f_{PM-1} \cdot f_{PM}} \right|$$

Der maximale Gesamtfehler $F_{MAX}$ einer halben PM-Periode kann abgeschätzt durch:

$$F_{max} = \left| \sum_{T/2} F \right| < f_{max} \cdot \frac{f_{MAX} - f_{MIN}}{f_{MIN} \cdot f_{MIN}}$$

Diese Abschätzung setzt sich insbesondere aus drei Überlegungen zusammen:

- Rest R kann nie größer werden als die aktuelle Frequenz $f_{PM}$. Wird der Rest R durch die maximale Frequenz $f_{MAX}$ ersetzt, dann erfolgt eine Abschätzung nach oben.

- Der Fehler wird maximal, je kleiner der Nenner wird, daher ersetzen wir die Frequenzen $f_{PM-1}$ und $f_{PM}$ jeweils durch $f_{MIN}$.

- Durch die Iterationsformel ergibt sich eine Summe der Zähler in der Form: $f_1 - f_2 + f_2 - f_3 + f_3 - f_4... = f_{MAX} - f_{MIN}$.

Benötigt man eine Abschätzung in %, dann kann man noch durch die minimale PM-Frequenz $f_{MIN}$ teilen und man erhält:

$$F_{MAX}(\%) < \frac{f_{MAX} \cdot (f_{MAX} - f_{MIN})}{f_{MIN} \cdot f_{MIN} \cdot f_{MIN}}$$

Für beispielhafte Frequenzmodulationen ergeben sich folgende Ergebnisse für den maximalen Gesamtfehler einer halben PM-Periode:

$$\text{Beispiel 1:} \qquad f = 10\,\text{kHz} \pm 1\,\text{kHz}$$

$$F_{MAX} < \frac{11 \cdot 2}{9 \cdot 9 \cdot 9 \cdot 1000} \approx 0{,}00301\%$$

$$\text{Beispiel 2:} \qquad f = 100\,\text{Hz} \pm 10\,\text{Hz}$$

$$F_{MAX} < \frac{110 \cdot 20}{90 \cdot 90 \cdot 90} \approx 0{,}301\%$$

Um den Fehler zu minimieren, dienen die Extremstellen $f_{MIN}$ und $f_{MAX}$ bevorzugt als Stützstellen, an denen die rekursive Berechnung neu aufgesetzt wird, indem zur Berechnung von $f_{PM+1,}$ bei Überschreitung/Gleichheit der PM-Frequenz, $f_{MAX} = f_{PM}$ bzw. $f_{MIN} = f_{PM}$ gesetzt wird.

**Patentansprüche**

1. Verfahren zur pulsmodulierten Ansteuerung eines Verbrauchers in einem Fahrzeug, wobei eine Periodendauer ($T_{PM}$) der Pulsmodulation in eine ganzzahlige Anzahl (N) an Abschnitten ($T_{STEP}$) unterteilbar ist, deren Dauer jeweils einem Vielfachen einer Periodendauer ($T_{OSC}$) eines Taktsignals entspricht, wobei dieses die Schritte aufweist:

    - Berechnen einer Frequenz ($f_{PM+1}, f_{PM}$) oder Periodendauer ($T_{PM+1}, T_{PM}$) einer Periode der Pulsmodulation auf Basis einer zugrundeliegenden Frequenzmodulation und
    - Festlegen der Dauer eines jeweiligen Abschnittes ($T_{STEP}$) einer Periodendauer ($T_{PM}$) der Pulsmodulation unter Heranziehung der berechneten Frequenz ($f_{PM+1}$,$f_{PM}$) oder Periodendauer ($T_{PM+1}$,$T_{PM}$) einer Periode der Pulsmodulation,

**dadurch gekennzeichnet, dass**

zur Bestimmung der Dauer ($T_{STEP}$) der Abschnitte einer Periode der Pulsmodulation die folgenden Schritte vorgenommen werden, wobei $R_{STEP}$ einen Restwert, fosc eine Frequenz des Taktsignals, N die Anzahl Abschnitte und $f_{PM}$ die Frequenz der Pulsmodulation repräsentiert:

1. Initialisierung des Rests ($R_{STEP}$) mit einem Wert gleich Null zu Beginn einer Periode der Pulsmodulation,

$$R_{STEP} = R_{STEP} + \frac{f_{OSC}}{N} - f_{PM}$$

2. Ausführung einer Zuweisung: am Anfang eines Abschnitts,

3. Ausführung einer Zuweisung: $R_{STEP} = R_{STEP} - f_{PM}$ im Anschluss einer Periode des Taktsignals und

4. Beendigung des Abschnitts und Ausführung des 2. Schrittes, wenn der Rest ($R_{STEP}$) kleiner ist als die Frequenz der Pulsmodulation ($f_{PM}$), und andernfalls Wiederholung des 3. Schrittes.

2. Verfahren gemäß Anspruch 1, **dadurch gekennzeichnet, dass** die Berechnung der Frequenz ($f_{PM+1}$,$f_{PM}$) oder Periodendauer ($T_{PM+1}$,$T_{PM}$) einer Periode der Pulsmodulation mittels einer rekursiven Berechnung erfolgt, wobei eine Frequenz ($f_{PM-1}$) oder Periodendauer ($T_{PM-1}$) einer vorhergehenden Periode der Pulsmodulation herangezogen wird.

3. Verfahren gemäß wenigstens einem der Ansprüche 1 oder 2, **dadurch gekennzeichnet, dass** die Frequenz ($f_{PM+1}$) oder Periodendauer ($T_{PM+1}$) einer nachfolgenden Periode der Pulsmodulation während einer laufenden Periode der Pulsmodulation berechnet wird.

4. Verfahren gemäß wenigstens einem der Ansprüche 1 bis 3, **dadurch gekennzeichnet, dass** die Frequenz ($f_{PM+1}$) oder Periodendauer ($T_{PM+1}$) der nachfolgenden Periode der Pulsmodulation während einer laufenden Periode der Pulsmodulation genau einmal berechnet wird.

5. Verfahren gemäß wenigstens einem der Ansprüche 1 bis 4, **dadurch gekennzeichnet, dass** die zugrundeliegende Frequenzmodulation einem vorgegebenen Frequenzänderungsverlauf folgt.

6. Verfahren gemäß wenigstens einem der Ansprüche 1 bis 5, **dadurch gekennzeichnet, dass** für die Berechnung der Frequenz ($f_{PM+1}$,$f_{PM}$) oder Periodendauer ($T_{PM+1}$,$T_{PM}$) der Periode der Pulsmodulation die Näherung herangezogen wird, dass die Frequenzen ($f_{PM+1}$,$f_{PM}$) aufeinanderfolgender Perioden der Pulsmodulation oder die Periodendauern ($T_{PM+1}$,$T_{PM}$) der Pulsmodulation gleich sind.

7. Verfahren gemäß wenigstens einem der Ansprüche 1 bis 6, **dadurch gekennzeichnet, dass** die Dauer ($T_{STEP}$) der Abschnitte einer Periode der Pulsmodulation unter Heranziehung der Frequenz ($f_{PM}$) oder Periodendauer ($T_{PM}$) einer laufenden Periode der Pulsmodulation iterativ für jeden Abschnitt separat bestimmt wird.

8. Verfahren gemäß Anspruch 7, **dadurch gekennzeichnet, dass** die Dauer ($T_{STEP}$) eines jeweiligen Abschnittes der Periodendauer ($T_{PM}$) der Pulsmodulation weiterhin auf Grundlage eines Verhältniswerts ($V_{PM}$) der Dauer eines Abschnittes ($T_{STEP}$) zur Periodendauer ($T_{OSC}$) des Taktsignals bestimmt wird.

9. Elektronische Vorrichtung zur pulsmodulierten Ansteuerung eines Verbrauchers in einem Fahrzeug, welche derart ausgestaltet ist, um das Verfahren nach einem der Ansprüche 1 bis 8 auszuführen, wobei die elektronische Vorrichtung zumindest einen Schaltkreis zur Erzeugung eines pulsmodulierten Signals der Pulsmodulation aufweist, der unter Heranziehung des Taktsignals betreibbar ist, wobei eine Periodendauer ($T_{PM}$) des pulsmodulierten Signals in eine ganzzahlige Anzahl (N) an Abschnitten ($T_{STEP}$) unterteilbar ist, deren Dauer jeweils einem Vielfachen einer Periodendauer ($T_{OSC}$) des Taktsignals entspricht, wobei der Schaltkreis zur Erzeugung eines pulsmodulierten Signals unterschiedlicher Periodendauern ($T_{PM}$) oder Frequenzen ($f_{PM+1}$,$f_{PM}$) ausgestaltet ist, wobei das pulsmodulierte Signal innerhalb einer Periodendauer ($T_{PM}$) einen nicht ganzzahligen Mittelwert von Verhältniswerten ($V_{PM}$) der Dauer der Abschnitte ($T_{STEP}$) einer Periode der Pulsmodulation zur Periodendauer ($T_{OSC}$) des Taktsignals aufweisen kann

10. Elektronische Vorrichtung gemäß Anspruch 9, **dadurch gekennzeichnet, dass** der Schaltkreis ausgestaltet ist, innerhalb einer Periodendauer ($T_{PM}$) des pulsmodulierten Signals Abschnitte unterschiedlicher Zeitdauern ($T_{STEP}$) zu erzeugen.

**Claims**

1. Method for the pulse-modulated actuation of a load in a vehicle, a period duration ($T_{PM}$) of the pulse modulation being able to be divided into an integer number (N) of sections ($T_{STEP}$), the duration of each of which corresponds to a multiple of a period duration ($T_{OSC}$) of a clock signal, wherein the method has the steps of:

- calculating a frequency ($f_{PM+1}$, $f_{PM}$) or period duration ($T_{PM+1}$, $T_{PM}$) of a period of the pulse modulation on the basis of underlying frequency modulation, and
- determining the duration of a respective section ($T_{STEP}$) of a period duration ($T_{PM}$) of the pulse modulation using the calculated frequency ($f_{PM+1}$, $f_{PM}$) or period duration ($T_{PM+1}$, $T_{PM}$) of a period of the pulse modulation, **characterized in that**
the following steps are carried out in order to determine the duration ($T_{STEP}$) of the sections of a period of the pulse modulation, where $R_{STEP}$ represents a remainder value, $f_{OSC}$ represents a frequency of the clock signal, N represents the number of sections and $f_{PM}$ represents the frequency of the pulse modulation:

   1. Initializing the remainder ($R_{STEP}$) with a value equal to zero at the beginning of a period of the pulse modulation,
   2. Performing an allocation: $R_{STEP} = R_{STEP} + \dfrac{f_{OSC}}{N} - f_{PWM}$ at the start of a section,
   3. Performing an allocation: $R_{STEP} = R_{STEP} - f_{PM}$ after a period of the clock signal, and
   4. Terminating the section and performing the second step if the remainder ($R_{STEP}$) is less than the frequency of the pulse modulation ($f_{PM}$), and otherwise repeating the third step.

2. Method according to Claim 1, **characterized in that** the frequency ($f_{PM+1}$, $f_{PM}$) or period duration ($T_{PM+1}$, $T_{PM}$) of a period of the pulse modulation is calculated by means of a recursive calculation, a frequency ($f_{PM-1}$) or period duration ($T_{PM-1}$) of a preceding period of the pulse modulation being used.

3. Method according to at least either of Claims 1 and 2, **characterized in that** the frequency ($f_{PM+1}$) or period duration ($T_{PM+1}$) of a subsequent period of the pulse modulation is calculated during an ongoing period of the pulse modulation.

4. Method according to at least one of Claims 1 to 3, **characterized in that** the frequency ($f_{PM+1}$) or period duration ($T_{PM+1}$) of the subsequent period of the pulse modulation is calculated precisely once during an ongoing period of the pulse modulation.

5. Method according to at least one of Claims 1 to 4, **characterized in that** the underlying frequency modulation follows a predefined frequency change profile.

6. Method according to at least one of Claims 1 to 5, **characterized in that** the approximation that the frequencies ($f_{PM+1}$, $f_{PM}$) of successive periods of the pulse modulation or the period durations ($T_{PM+1}$, $T_{PM}$) of the pulse modulation are approximately the same is used to calculate the frequency ($f_{PM+1}$, $f_{PM}$) or period duration ($T_{PM+1}$, $T_{PM}$) of the period of the pulse modulation.

7. Method according to at least one of Claims 1 to 6, **characterized in that** the duration ($T_{STEP}$) of the sections of a period of the pulse modulation is iteratively determined separately for each section using the frequency ($f_{PM}$) or period duration ($T_{PM}$) of an ongoing period of the pulse modulation.

8. Method according to Claim 7, **characterized in that** the duration ($T_{STEP}$) of a respective section of the period duration ($T_{PM}$) of the pulse modulation is also determined on the basis of a ratio value ($V_{PM}$) of the duration of a section ($T_{STEP}$) to the period duration ($T_{OSC}$) of the clock signal.

9. Electronic device for the pulse-modulated actuation of a load in a vehicle, which device is configured in such a manner as to execute the method according to one of Claims 1 to 8, wherein the electronic device has at least one circuit for generating a pulse-modulated signal of the pulse modulation, which circuit can be operated using the clock signal, a period duration ($T_{PM}$) of the pulse-modulated signal being able to be divided into an integer number (N) of sections ($T_{STEP}$), the duration of each of which corresponds to a multiple of a period duration ($T_{OSC}$) of the clock signal, wherein the circuit is configured to generate a pulse-modulated signal of different period durations ($T_{PM}$) or frequencies ($f_{PM+1}$, $f_{PM}$), the pulse-modulated signal being able to have, within a period duration ($T_{PM}$), a non-integer mean value of ratio values ($V_{PM}$) of the duration of the sections ($T_{STEP}$) of a period of the pulse modulation to the period duration ($T_{OSC}$) of the clock signal.

10. Electronic device according to Claim 9, **characterized in that** the circuit is configured to generate sections of different time periods ($T_{STEP}$) within a period duration ($T_{PM}$) of the pulse-modulated signal.

## Revendications

1. Procédé de commande par modulation d'impulsions d'un récepteur dans un véhicule, une durée de période ($T_{PM}$) de la modulation d'impulsions pouvant être divisée en un nombre entier (N) de portions ($T_{STEP}$) dont la durée correspond respectivement à un multiple de la durée de période ($T_{OSC}$) d'un signal d'horloge, celui-ci comprenant les étapes suivantes :

- calcul d'une fréquence ($f_{PM+1}$, $f_{PM}$) ou d'une durée de période ($T_{PM+1}$, $T_{PM}$) d'une période de la modulation d'impulsions sur la base d'une modulation de fréquence sous-jacente et
- fixation de la durée d'une portion ($T_{STEP}$) respective d'une durée de période ($T_{PM}$) de la modulation d'impulsions en faisant appel à la fréquence ($f_{PM+1}$, $f_{PM}$) calculée ou à la durée de période ($T_{PM+1}$, $T_{PM}$) calculée d'une période de la modulation d'impulsions,

**caractérisé en ce que**
les étapes suivantes sont exécutées pour déterminer la durée ($T_{STEP}$) des portions d'une période de la modulation d'impulsions, $R_{STEP}$ représentant une valeur résiduelle, $f_{OSC}$ une fréquence du signal d'horloge, N le nombre de portions et $f_{PM}$ la fréquence de la modulation d'impulsions :

1. initialisation du reste ($R_{STEP}$) à une valeur égale à zéro au début d'une période de la modulation d'impulsions,

2. réalisation d'une assignation : $R_{STEP} = R_{STEP} + \dfrac{f_{osc}}{N} - f_{PM}$ au début d'une portion,

3. réalisation d'une assignation : $R_{STEP} = R_{STEP} - f_{PM}$ à la fin d'une période du signal d'horloge et

4. terminaison de la portion et exécution de la 2ème étape lorsque le reste ($R_{STEP}$) est inférieur à la fréquence de la modulation d'impulsions ($f_{PM}$) et sinon répétition de la 3ème étape.

2. Procédé selon la revendication 1, **caractérisé en ce que** le calcul de la fréquence ($f_{PM+1}$, $f_{PM}$) ou de la durée de période ($T_{PM+1}$, $T_{PM}$) d'une période de la modulation d'impulsions est réalisé au moyen d'un calcul récursif, une fréquence ($f_{PM-1}$) ou une durée de période ($T_{PM-1}$) d'une période précédente de la modulation d'impulsions étant utilisée.

3. Procédé selon au moins l'une des revendications 1 et 2, **caractérisé en ce que** la fréquence ($f_{PM+1}$) ou la durée de période ($T_{PM+1}$) d'une période suivante de la modulation d'impulsions est calculée pendant une période courante de la modulation d'impulsions.

4. Procédé selon au moins l'une des revendications 1 à 3, **caractérisé en ce que** la fréquence ($f_{PM+1}$) ou la durée de période ($T_{PM+1}$) de la période suivante de la modulation d'impulsions est calculée exactement une fois pendant une période courante de la modulation d'impulsions.

5. Procédé selon au moins l'une des revendications 1 à 4, **caractérisé en ce que** la modulation de fréquence sous-jacente suit un tracé de modification de fréquence prédéfini.

6. Procédé selon au moins l'une des revendications 1 à 5, **caractérisé en ce que** le calcul de la fréquence ($f_{PM+1}$, $f_{PM}$) ou de la durée de période ($T_{PM+1}$, $T_{PM}$) de la période de la modulation d'impulsions fait appel à l'approximation selon laquelle les fréquences ($f_{PM+1}$, $f_{PM}$) de périodes successives de la modulation d'impulsions ou les durées de période ($T_{PM+1}$, $T_{PM}$) de la modulation d'impulsions sont les mêmes.

7. Procédé selon au moins l'une des revendications 1 à 6, **caractérisé en ce que** la durée ($T_{STEP}$) des portions d'une période de la modulation d'impulsions est déterminée séparément de manière itérative pour chaque portion en faisant appel à la fréquence ($f_{PM}$) ou à la durée de période ($T_{PM}$) d'une période courante.

8. Procédé selon la revendication 7, **caractérisé en ce que** la durée ($T_{STEP}$) d'une portion respective de la durée de période ($T_{PM}$) de la modulation d'impulsions est en outre déterminée sur la base d'une valeur de rapport ($V_{PM}$) entre la durée d'une portion ($T_{STEP}$) et la durée de période ($T_{OSC}$) du signal d'horloge.

9. Dispositif électronique de commande par modulation d'impulsions d'un récepteur dans un véhicule, lequel est configuré pour mettre en œuvre le procédé selon l'une des revendications 1 à 8, le dispositif électronique possédant au moins un circuit destiné à générer un signal modulé en impulsions de la modulation d'impulsions, lequel peut fonctionner en faisant appel au signal d'horloge, une durée de période ($T_{PM}$) du signal modulé en impulsions pouvant être divisée en un nombre entier ($N$) de portions ($T_{STEP}$) dont la durée correspond respectivement à un multiple de la durée de période ($T_{OSC}$) du signal d'horloge, le circuit étant configuré pour générer un signal modulé en impulsions ayant des durées de période ($T_{PM}$) ou des fréquences ($f_{PM+1}$, $f_{PM}$) différentes, le signal modulé en impulsions pouvant présenter à l'intérieur d'une durée de période ($T_{PM}$) une moyenne non entière de valeurs de rapport ($V_{PM}$) entre la durée des portions ($T_{STEP}$) d'une période de la modulation d'impulsions et la durée de période ($T_{OSC}$) du signal d'horloge.

10. Dispositif électronique selon la revendication 9, **caractérisé en ce que** le circuit est configuré pour générer des portions ayant des durées ($T_{STEP}$) différentes au sein d'une durée de période ($T_{PM}$) du signal modulé en impulsions.

$$T_{pwm} = N * T_{step}$$

Fig. 1

$$T_{pwm} = N * T_{step}$$

Fig. 2

Fig. 3

Fig. 4

$$a * \frac{b}{c} = 101 * \frac{1011101}{1001}$$

$$= ( 1010 + \frac{11}{1001} ) * 101$$

$$= 1010 * 101 + \frac{11}{1001} * 101$$

Fig. 5

$$T_{pwm} = N * T_{step}$$

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012213874 A1
- US 2008157894 A1
- US 2013015798 A1